# EUROPÄISCHE PATENTSCHRIFT

(11) **EP 1 033 525 B1**
(45) Veröffentlichungstag und Bekanntmachung des Hinweises auf die Patenterteilung: **27.09.2006**
(21) Anmeldenummer: 00101386.1
(22) Anmeldetag: 24.01.2000
(51) Int. Cl.: F21S 8/10, H01L 25/13, F21W 101/14, F21Y 101/02

(54) **Flexibles LED-Mehrfachmodul, insbesondere für ein Leuchtgehäuse eines Kraftfahrzeuges**
Flexible LED-Multimodule, in particular for a vehicle lamp housing
Système flexible à diodes électroluminescentes , notamment pour un boîtier de lampe du véhicule

(30) Priorität: 04.03.1999 DE 19909399
(43) Veröffentlichungstag der Anmeldung: 06.09.2000
(73) Patentinhaber: Osram Opto Semiconductors GmbH & Co. OHG, 93049 Regensburg (DE)
(72) Erfinder: Bachl, Bernhard, 93055 Regensburg (DE); Waitl, Günter, 93049 Regensburg (DE)
(74) Vertreter: Epping - Hermann - Fischer

(56) Entgegenhaltungen:
- DE-U- 29 919 817
- FR-A- 2 601 486
- US-A- 5 084 804
- US-A- 5 519 596

## Beschreibung

Die Erfindung betrifft ein flexibles LED-Mehrfachmodul, welches insbesondere in ein Leuchtengehäuse eingebaut werden kann, wie es beispielsweise bei Außenleuchten von Kraftfahrzeugen verwendet werden kann.

Im Bereich der Außen- und Innenbeleuchtung von Kraftfahrzeugen, insbesondere für Rücklichter oder Bremsleuchten werden in zunehmendem Maße Lichtemissionsdioden (LEDs) anstelle der konventionellen Glühlampen eingesetzt, da LEDs eine längere Lebensdauer, einen besseren Wirkungsgrad bei der Umwandlung elektrischer in Strahlungsenergie im sichtbaren Spektralereich, damit verbunden eine geringere Wärmeabgabe und insgesamt geringeren Platzbedarf aufweisen. Im Aufbau muß jedoch zunächst ein gewisser Mehraufwand getrieben werden, denn aufgrund der geringen Leuchtdichte einer einzelnen LED im Vergleich zu einer Glühlampe muß eine zu einem Array geformte Mehrzahl von LEDs aufgebaut werden.

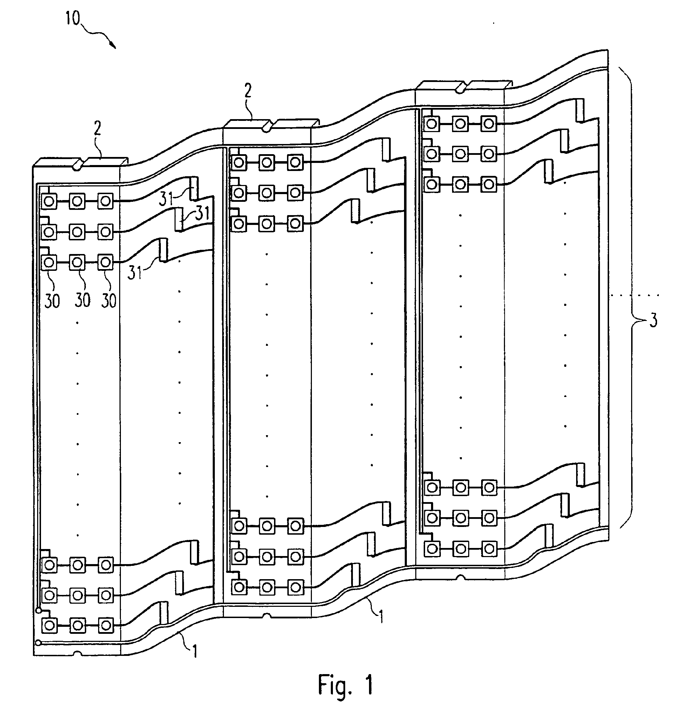

Zur Realisierung eines LED-Arrays sind bisher mehrere Vorschläge bekannt geworden. So beschreibt die US 5404282 ein LED-Modul, bei welchem eine Anzahl LEDs zwischen zwei parallelen, elektrisch leitenden Stäben fest montiert werden. Diese Anordnung ist schaltungstechnisch relativ effizient, aber ansonsten für den Einbau in ein Leuchtengehäuse relativ unflexibel, da sie nicht einfach an gekrümmte Gehäuseformen anpaßbar ist (vgl. Figur 1 dort).

In der US 5519596 ist ferner ein LED-Modul beschrieben, welches aus einem metallischen Rahmen aufgebaut ist, der starre Abschnitte, in denen LEDs zwischen elektrisch leitenden Stegen kontaktiert sind, und flexible Abschnitte aufweist, die zwischen den starren Abschnitten eingesetzt sind und die jeweils aus einer metallischen, kammartigen und verbiegbaren Struktur aufgebaut sind. Diese Anordnung liefert zwar die gewünschte Flexibilität, bringt dafür aber Nachteile mit sich. Zum einen ist aufgrund der Tatsache, daß der gesamte Rahmen aus Metall gefertigt ist, die Herstellung der flexiblen Abschnitte zu aufwendig und schwierig und andererseits erlaubt das Schaltungskonzept jeweils nur die Anordnung von einer Reihe von LEDs in einem Modulabschnitt.

Es ist daher Aufgabe der vorliegenden Erfindung, ein flexibles LED-Mehrfachmodul insb. für ein Leuchtgehäuse eines Kraftfahrzeuges anzugeben, welches einerseits möglichst einfach hergestellt werden kann und andererseits die Anordnung einer großen Anzahl von LEDs in den einzelnen Modulabschnitten ermöglicht.

Diese Aufgabe wird durch die Merkmale des Patentanspruchs 1 gelöst. Demgemäß beschreibt die Erfindung ein flexibles LED-Mehrfachmodul, welches eine Mehrzahl, beispielsweise aus Aluminium bestehender, starrer oder rigider Leiterplatten aufweist, die jeweils an einer ihrer Hauptoberflächen mit einer flexiblen Leiterplatte mit einem Abstand voneinander verbunden sind, und einer Mehrzahl von LEDs, die im Bereich der starren Leiterplatten auf der flexiblen Leiterplatte montiert sind.

Bevorzugterweise sind die LEDs in einen Schaltkreis integriert, der auf der flexiblen Leiterplatte aufgebracht ist. Die LEDs werden bevorzugterweise in der Oberflächenmontagetechnik SMT (Surface-Mount Technology) hergestellt und direkt auf der flexiblen Leiterplatte in dem Bereich montiert, in dem die flexible Leiterplatte auf den starren Leiterplatten aufgeklebt ist. Dies hat den Vorteil, daß für eine optimale Wärmeableitung von den LEDs gesorgt ist.

Eine bevorzugt verwendete LED ist beispielsweise in dem Artikel "SIEMENS SMT-TOPLED für die Oberflächenmontage" von F. Möllmer und G. Waitl in der Zeitschrift Siemens Components 29 (1991), Heft 4,S.147f im Zusammenhang mit Bild 1 beschrieben.

Diese Form der LED ist äußerst kompakt und erlaubt die Anordnung einer Vielzahl von LEDs auf der flexiblen Leiterplatte.

Die flexible Leiterplatte ist in der Regel aus einem flexiblen Kunststoff hergestellt. Sie kann beispielsweise aus einer Polyester- oder Polyimidfolie bestehen. Besonders bevorzugt ist die Verwendung sogenannter, an sich im Stand der Technik bekannter Flexboards, wie sie beispielsweise in dem Artikel "Flexibel verdrahten auf kleinstem Raum" von H. Kober in der Zeitschrift F & M, Heft 5/96, S. 356f, beschrieben sind. Diese Flexboards werden dort als mehrlagige Leiterplatten beschrieben, die homogen aus einer Mehrzahl von Polyimidträgerfolien aufgebaut sind.

Weiterhin bevorzugt ist, daß in dem Schaltkreis enthaltene Widerstände im Bereich der Abstände zwischen den starren Leiterplatten auf den flexiblen Abschnitten der flexiblen Leiterplatte aufgebracht sind. Damit können die Widerstände gewissermaßen thermisch abgekoppelt werden.

Das erfindungsgemäße LED-Mehrfachmodul eignet sich besonders für den Einbau in ein Leuchtengehäuse für die Umgebungsbeleuchtung, insbesondere für ein Kraftfahrzeug, beispielsweise für Rück- oder Bremsleuchten.

Im folgenden wird die Erfindung anhand von Ausführungsbeispielen näher erläutert. Es zeigen:
Fig.1 eine Draufsicht auf die Grundform eines erfindungsgemäßen LED-Mehrfachmoduls;
Fig.2 eine perspektivische Ansicht einer erweiterten Form eines erfindungsgemäßen LED-Mehrfachmoduls;
Fig.3A,B eine Seitenansicht und eine Draufsicht auf ein Leuchtengehäuse mit einem darin eingesetzten LED-Mehrfachmodul.

Die in Fig.1 dargestellte Grundform eines LED-Mehrfachmoduls weist eine Anzahl von stabförmigen, starren Leiterplatten 2 auf, die im Prinzip aus jedem starren Festkörpermaterial gefertigt werden können. Vorzugsweise bestehen sie aus einem Metall, da eine gute Wärmeableitung wünschenswert ist. Hier bietet sich insbesondere Aluminium an, da es im übrigen auch gut bearbeitbar ist und ein niedriges spezifisches Gewicht aufweist, was im Hinblick auf den Einsatz im Kraftfahrzeug von Bedeutung ist. Diese starren Leiterplatten 2 werden wie dargestellt im Abstand voneinander angeordnet und eine flexible Leiterplatte 1, vorzugsweise ein Flexboard, wird auf die starren Leiterplatten 2 aufgeklebt. Die Technologie des Aufklebens von Flexboards auf Metalloberflächen ist im Stand der Technik bekannt und soll hier nicht weiter vertieft werden.

Dann wird auf die flexible Leiterplatte 2 ein Schaltkreis 3, der LEDs 30 und gegebenenfalls Widerstände 31 enthält, vorzugsweise in der bekannten SMT-Technik, durch Löten aufgebracht. Die LEDs 30 werden dabei in den Bereichen der starren Leiterplatten 2 montiert und die Widerstände 31 werden in den Bereichen der zwischen den starren Leiterplatten 1 liegenden flexiblen Abschnitte des Flexboards montiert. Die LEDs sind vorzugsweise wie die bereits genannten SMT-TOPLED® geformt.

Bei der Herstellung werden die starren Leiterplatten 2 derart aus einem Grundkörper ausgefräst, daß sie anfänglich noch durch schmale Stege miteinander verbunden sind. Erst nach dem Aufkleben der flexiblen Leiterplatte und dem Auflöten des Schaltkreises 3 werden die Stege unterhalb der flexiblen Abschnitte der flexiblen Leiterplatte 1 entfernt und somit die volle Flexibilität des LED-Mehrfachmoduls 10 hergestellt. Die Stege können mit geeigneten Stützelementen an den Stellen versehen sein, an denen durch die SMT-Montage die Widerstände 31 montiert werden sollen. Diese Stützelemente bilden eine Art Widerlager unterhalb der flexiblen Leiterplatte 1 für die von oberhalb der flexiblen Leiterplatte 1 zu erfolgende Auflötung der Widerstände 31.

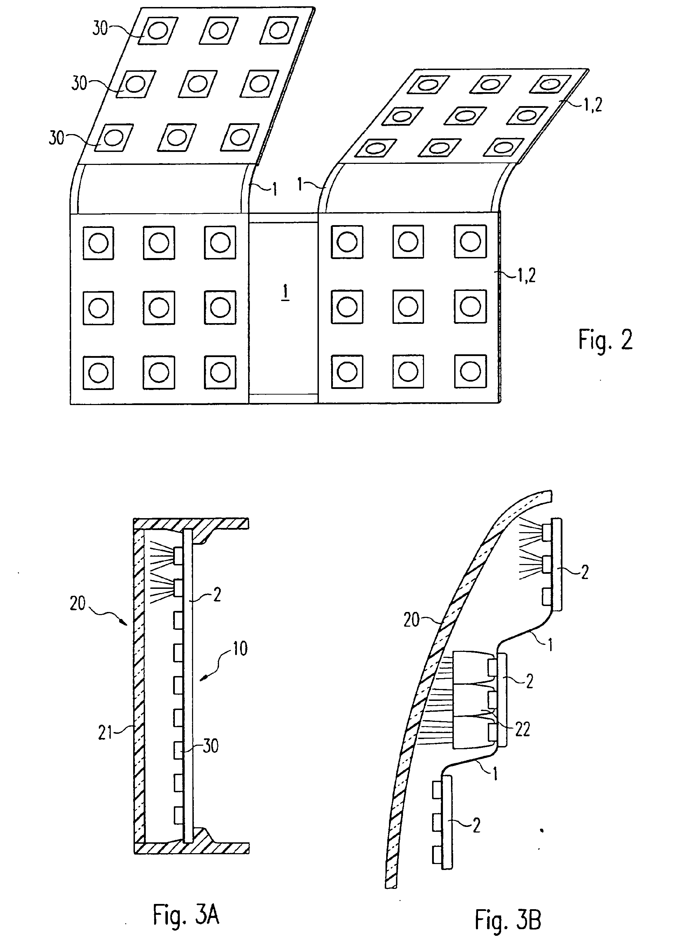

In Fig.2 ist eine erweiterte Form eines erfindungsgemäßen LED-Mehrfachmoduls dargestellt. Während die Grundform der Fig.1 eine gewissermaßen eindimensionale Anordnung einer Mehrzahl von LED-Modulen in einer Richtung darstellt, zeigt die Ausführungsform der Fig.2, daß die Module auch entlang zweier Richtungen auf der flexiblen Leiterplatte 1 angeordnet werden können.

In den Figuren 3A und 3B sind eine Seitenansicht und eine Draufsicht auf ein Leuchtengehäuse 20 dargestellt, in welches das erfindungsgemäße LED-Modul 10 eingesetzt ist. Das Gehäuse 20 besteht vorzugsweise aus Kunststoff und weist an seinen Innenwänden in den Kunststoff gespritzte Nuten auf, in die die starren Leiterplatten 2 einschnappen können. Auf diese Weise kann das LED-Modul sicher in dem Leuchtengehäuse fixiert werden, so daß - wie in Fig.3B gezeigt - alle LEDs 30 der Module in einer definierten Abstrahlrichtung emittieren.

Die transparente Frontfläche 21 des Leuchtengehäuses 20 kann gewünschtenfalls eine Vielzahl von Linsen zur Bündelung des von den LEDs 30 emittierten Lichts enthalten. Es kann auch vorgesehen sein, daß zusätzliche optische Elemente 22 zur Strahlführung und/oder -bündelung unmittelbar vor die Lichtaustrittsfläche der LEDs 30 gesetzt werden.

Insbesondere kann vorgesehen sein, daß beispielsweise durch entsprechende Ausgestaltung der seitlichen Montagenuten in der Innenwand des Leuchtengehäuses 20 die Winkelstellung der Einzelmodule im eingebauten Zustand geändert werden kann. Durch die Änderung der Winkelstellung kann insbesondere die Leuchtdichteverteilung verändert werden, um bestimmte gesetzliche Auflagen zu erfüllen.

## Patentansprüche

1. Flexibles LED-Mehrfachmodul (10), insbesondere für ein Leuchtengehäuse (20) eines Kraftfahrzeuges, mit
- einer Mehrzahl starrer Leiterplatten (2), die
- jeweils an einer ihrer Hauptoberflächen mit einer flexiblen Leiterplatte (1) mit einem Abstand voneinander verbunden sind, und
- einer Mehrzahl von LEDs (30), die im Bereich der starren Leiterplatten (2) auf der flexiblen Leiterplatte (1) montiert sind.

2. Flexibles LED-Mehrfachmodul (10) nach Anspruch 1,
**dadurch gekennzeichnet, daß**
- die LEDs (30) in einen Schaltkreis (3) integriert sind, der auf der flexiblen Leiterplatte (1) aufgebracht ist.

3. Flexibles LED-Mehrfachmodul (10) nach Anspruch 2,
**dadurch gekennzeichnet, daß**
- der Schaltkreis (3) Widerstände (31) aufweist, die im Bereich der Abstände zwischen den starren Leiterplatten (2) auf der flexiblen Leiterplatte (1) aufgebracht sind.

4. Flexibles LED-Mehrfachmodul (10) nach Anspruch 1,
**dadurch gekennzeichnet, daß**
- die starren Leiterplatten (2) aus Aluminium bestehen.

5. Flexibles LED-Mehrfachmodul (10) nach Anspruch 1,
**dadurch gekennzeichnet, daß**
- die flexible Leiterplatte (1) aus einem Kunststoff, insbesondere Polyester oder Polyimid, besteht, und insbesondere aus mehreren Lagen aus Polyimid aufgebaut ist (Flexboard).

6. Verwendung eines flexiblen LED-Mehrfachmoduls nach einem der Ansprüche 1 bis 5 in einem Leuchtengehäuse (20) für ein Kraftfahrzeug.

## Claims

1. Flexible multiple LED module (10), in particular for a luminaire housing (20) of a motor vehicle, having
- a plurality of rigid circuit boards (2), which
- are each connected at one of their main surfaces to a flexible circuit board (1) with a spacing between one another, and
- a plurality of LEDs (30), which are mounted in the region of the rigid circuit boards (2) on the flexible circuit board (1).

2. Flexible multiple LED module (10) according to Claim 1,
**characterized in that**
- the LEDs (30) are integrated in an electric circuit (3) applied on the flexible circuit board (1).

3. Flexible multiple LED module (10) according to Claim 2,
**characterized in that**
- the electric circuit (3) has resistors (31) applied in the region of the spacings between the rigid circuit boards (2) on the flexible circuit board (1).

4. Flexible multiple LED module (10) according to Claim 1,
**characterized in that**
- the rigid circuit boards (2) are composed of aluminum.

5. Flexible multiple LED module (10) according to Claim 1,
**characterized in that**
- the flexible circuit board (1) is composed of a plastic, in particular polyester or polyimide, and, in particular, is constructed from a plurality of layers of polyimide (flexboard).

6. Use of a flexible multiple LED module according to one of Claims 1 to 5 in a luminaire housing (20) for a motor vehicle.

## Revendications

1. Module flexible (10) à plusieurs LED, en particulier pour un boîtier (20) de phare d'un véhicule automobile, qui présente :
- plusieurs cartes rigides de circuits (2)
- qui sont toutes reliées à distance l'une de l'autre et par leur surface principale à une carte flexible de circuits (1) et
- plusieurs LED (30) qui sont montées sur les cartes flexibles de circuits (1) dans la zone des cartes rigides de circuits (2).

2. Module flexible (10) à plusieurs LED selon la revendication 1, **caractérisé en ce que** les LED (30) sont intégrées dans des circuits (3) appliqués sur les cartes flexibles de circuits (1).

3. Module flexible (10) à plusieurs LED selon la revendication 2, **caractérisé en ce que** les circuits (3) présentent des résistances (31) qui sont appliquées sur les cartes flexibles de circuits (1) dans la zone des écarts entre les cartes rigides de circuits(2).

4. Module flexible (10) à plusieurs LED selon la revendication 1, **caractérisé en ce que** les cartes rigides de circuits (2) sont constituées de l'aluminium.

5. Module flexible (10) à plusieurs LED selon la revendication 1, **caractérisé en ce que** les cartes flexibles de circuits (1) sont constituées d'une matière synthétique, en particulier de polyester ou de polyimide, et en particulier de plusieurs couches de polyimide ("flexboard").

6. Utilisation d'un module flexible à plusieurs LED selon l'une des revendications 1 à 5 dans un boîtier (20) de phare d'un véhicule automobile.
